# FASCICULE DE BREVET EUROPEEN

(11) **EP 4 222 516 B1**
(45) Date de publication et mention de la délivrance du brevet: **19.02.2025**
(21) Numéro de dépôt: 21785892.7
(22) Date de dépôt: 30.09.2021
(51) Int. Cl.: G01R 33/56, G01N 24/08

(54) **MÉTHODE DE DÉTECTION ET DE QUANTIFICATION DE POLYSACCHARIDES DANS UNE MATRICE PÉTROLIÈRE OU COMPOSITION LUBRIFIANTE AQUEUSE**
VERFAHREN ZUM NACHWEIS UND ZUR QUANTIFIZIERUNG VON POLYSACCHARIDEN IN EINER ERDÖLMATRIX ODER EINER WÄSSRIGEN SCHMIERMITTELZUSAMMENSETZUNG
METHOD FOR DETECTING AND QUANTIFYING POLYSACCHARIDES IN A PETROLEUM MATRIX OR AQUEOUS LUBRICANT COMPOSITION

(30) Priorité: 30.09.2020 FR 2009995
(43) Date de publication de la demande: 09.08.2023
(73) Titulaire: TOTALENERGIES ONETECH, 92400 Courbevoie (FR)
(72) Inventeur: PONDAVEN, Simon, 69007 LYON (FR); FRELECHOUX, Richard, 69970 CHAPONNAY (FR); VIEL, Stéphane, 13008 MARSEILLE (FR); ZIARELLI, Fabio, 13260 CASSIS (FR)
(74) Mandataire: Lavoix
(86) Numéro de dépôt international: PCT/EP2021/076941
(87) Numéro de publication internationale: WO 2022/069628

(56) Documents cités:
- HAMMOND T E ET AL: "High resolution solid state 13C n.m.r. of Canadian peats", FUEL, IPC SIENCE AND TECHNOLOGY PRESS , GUILDFORD, GB, vol. 64, no. 12, 1 December 1985 (1985-12-01), pages 1687 - 1695, XP025455931, ISSN: 0016-2361, [retrieved on 19851201], DOI: 10.1016/0016-2361(85)90395-3

## Description

La présente invention concerne une méthode de détection de la présence d'au moins un polysaccharide dans une matrice pétrolière ou une composition lubrifiante aqueuse. La présente invention concerne l'utilisation de la résonance magnétique nucléaire en phase solide couplée à la polarisation dynamique nucléaire à basse température et à l'angle magique (technique dénommée plus simplement par « RMN DNP » dans la suite de ce document) pour identifier et quantifier la présence d'au moins un polysaccharide dans les matrices pétrolières ou les compositions lubrifiantes aqueuses.

Il est connu d'utiliser, dans les matrices pétrolières, notamment les compositions lubrifiantes, des additifs de type polysaccharide. L'ajout de polysaccharides est notamment connu dans les hydrolubes (compositions lubrifiantes comprenant majoritairement de l'eau ou composition lubrifiante aqueuse dans la suite de la description de l'invention). Ces polysaccharides présentent des hauts poids moléculaires et sont additionnés en très faible quantité dans les matrices pétrolières.

Il peut être intéressant de pouvoir analyser les matrices pétrolières et les compositions lubrifiantes aqueuses pour déterminer la présence éventuelle de polysaccharides et d'en déterminer la teneur, par exemple pour déterminer la qualité du processus de préparation desdites matrices pétrolières ou compositions lubrifiantes aqueuses notamment en cas de réclamation client sur les propriétés des matrices pétrolières ou compositions lubrifiantes aqueuses.

Cependant, du fait des faibles quantités utilisées, la détection de ces polysaccharides dans les matrices pétrolières ou compositions lubrifiantes aqueuses par les techniques d'analyse classiques n'est pas aisée et requiert un temps d'analyse important. Il est connu de l'article par HAMMOND T E ET AL: "High resolution solid state 13C n.m.r. of Canadian peats", FUEL, vol. 64, no. 12, pages 1687-1695 (1985) que par analyse RMN par rotation à l'angle magique et polarisation croisée du carbone ¹³C de la tourbe provenant du Canada et contenant du bitume et des polysaccharides, le pic à un déplacement chimique compris entre 90 ppm et 107 ppm correspond à l'atome de carbone anomérique du cycle osidique du polysaccharide. Pour leurs mesures, 5000 scans sont nécessaires pour chaque échantillon.

Il y a donc un intérêt à fournir une méthode d'analyse permettant de détecter la présence de polysaccharides dans une matrice pétrolière ou une composition lubrifiante aqueuse et de les quantifier.

Un objectif de la présente invention est donc de fournir une méthode permettant de détecter la présence de polysaccharides dans une matrice pétrolière ou une composition lubrifiante aqueuse.

Un autre objectif de la présente invention est également de fournir une telle méthode permettant de quantifier les polysaccharides présents dans ladite matrice pétrolière ou composition lubrifiante aqueuse.

D'autres objectifs encore apparaîtront à la lecture de la description de l'invention qui suit.

Ces objectifs sont remplis par la présente invention qui concerne une méthode selon la revendication 1 de détection de la présence d'au moins un polysaccharide dans une composition lubrifiante aqueuse ou une matrice pétrolière, comprenant les étapes suivantes :
a) l'analyse par RMN couplée à la polarisation nucléaire dynamique (DNP) en phase solide à basse température et à l'angle magique en phase solide de ladite composition lubrifiante aqueuse ou matrice pétrolière ;
b) la vérification de la présence d'un (ou de plusieurs) pic(s) à un déplacement chimique compris entre 90 ppm et 110 ppm, de préférence 103 ppm, correspondant à l'atome de carbone anomérique du cycle osidique du polysaccharide.

De façon particulièrement avantageuse, la méthode selon l'invention permet de s'abstenir de tout traitement préalable de la matrice pétrolière ou de la composition lubrifiante aqueuse. Ainsi, un échantillon de matrice pétrolière ou de composition lubrifiante aqueuse peut être analysé directement (moyennant l'ajout d'un agent de polarisation, voir plus avant).

Dans le cadre de la présente invention on entend par matrice pétrolière des compositions comprenant un mélange d'hydrocarbures et éventuellement de l'eau. On peut notamment citer le pétrole brut, les huiles de base (notamment celles utilisées dans les compositions lubrifiantes), les compositions lubrifiantes (notamment huile entière (une huile entière est de préférence une composition comprenant une huile de base et des additifs de performance par exemple choisis parmi les détergents par exemple dérivés phosphorés, sulfonate ou autre détergent, Oléfines soufrées) ou composition lubrifiante sous forme d'émulsion, ou encore les bitumes. Les matrices pétrolières comprenant de l'eau sont des émulsions et sont notamment choisies parmi les compositions lubrifiantes sous forme d'émulsions. Les compositions lubrifiantes sous forme d'émulsion comprennent de préférence de l'eau, une huile de base de type huile minérale ou ester, additifs tensioactifs (par exemple dérivés éthoxylés tel que alcools gras ethoxylés/propoxylés, ester phosphorique ethoxylés/propoxylés), des additifs notamment choisis parmi les biocides, les anti-mousses, etc.

Dans le cadre de la présente invention, on entend par composition lubrifiante aqueuse, des compositions lubrifiantes comprenant de l'eau, au moins un polymère hydrosoluble notamment de type ethoxylé/propoxylé (ester, polyalkylène glycol, etc), des additifs de type organique (acide carboxyliques, amine), et des additifs de type biocide, etc. Les compositions lubrifiantes aqueuses de la présente invention sont de préférence destinées à la lubrification dans le domaine des moteurs, notamment moteurs marins ou moteurs automobiles. Ces compositions lubrifiantes aqueuses sont connues sous la dénomination d'hydrolube.

De préférence, la méthode de l'invention est mise en oeuvre sur des compositions lubrifiantes aqueuses.

Dans le cadre de la présente invention, on entend par polysaccharides, des polymères constitués de plusieurs oses liés entre eux par des liaisons osidiques. De manière plus préférée, les polysaccharides visés par l'invention sont les celluloses et les galactomannanes, de préférence guars, ainsi que leurs dérivés.

L'objectif de la présente invention est de détecter par RMN DNP la présence d'un pic à un déplacement chimique compris entre 90 ppm et 110 ppm, de préférence 103 ppm correspondant à l'atome de carbone anomérique du cycle osidique du polysaccharide.

De préférence, les polysaccharides visés par l'invention ont une masse molaire comprise entre 10 et 2000 kg/mol, de préférence comprise entre 100 et 1000 kg/mol.

La méthode de l'invention peut également comprendre une étape de quantification des polysaccharides par comparaison de l'intensité du pic de l'étape b) susmentionnée à celle du pic équivalent (on entend par pic équivalent un pic caractérisé par un déplacement chimique similaire) du spectre RMN DNP d'une composition, de préférence analogue, comprenant une quantité connue d'un polysaccharide donné.

Lors de l'étape a) un agent de transfert de polarisation est ajouté à la matrice pétrolière ou à la composition lubrifiante aqueuse.

De préférence, cet agent de transfert de polarisation est choisi parmi toute espèce paramagnétique chimiquement compatible et disposant d'une efficacité DNP (c'est-à-dire une capacité à agir comme agent de polarisation DNP). De préférence, l'agent de transfert de polarisation est choisi parmi la famille des nitroxydes (incluant, par exemple mais sans limitation, les bisnitroxydes), des trityls, ou de leurs dérivés, de préférence les nitroxydes.

De préférence, l'agent de transfert de polarisation est ajouté dans une quantité comprise entre 1 mM et 100 mM, de préférence entre 5 mM et 20 mM, par exemple 15 mM.

L'étape de polarisation nucléaire dynamique peut être mise en oeuvre avec tout matériel connu de l'homme du métier, notamment à l'aide d'un gyrotron couplé à l'appareillage de RMN.

De préférence, l'étape de polarisation nucléaire dynamique de la matrice pétrolière est mise à une température comprise entre 20 K et 200 K, de préférence entre 90 et 120 K, par exemple 110 K.

De préférence, le rotor du système de polarisation nucléaire dynamique tourne à une fréquence comprise entre 1 kHz et 100 kHz, de préférence entre 1 et 50 kHz, par exemple 10 kHz.

De préférence, l'irradiation pour le transfert de la polarisation dans l'étape de polarisation nucléaire dynamique est comprise entre 100 GHz et 700 GHz, de préférence entre 200 et 500 GHz, par exemple 263 GHz.

De façon générale, la RMN-DNP est réalisée à l'angle magique et à basse température notamment à une température comprise 20 K et 200 K, de préférence entre 90 et 120 K, par exemple 110 K.

La polarisation peut être une polarisation croisée (ou cross polarization CP en anglais) ou une polarisation directe (DP). La CP permet une sensibilité et une rapidité de mesure plus importante, la DP est un peu moins sensible et nécessite donc des temps d'analyses plus importants.

La présente demande va maintenant être décrite à l'aide d'exemples non limitatifs.
[Fig 1] La figure 1 représente le spectre RMN d'une composition lubrifiante comprenant de l'eau et un polysaccharide obtenu par RMN DNP.
[Fig 2] La figure 2 représente deux spectres RMN DNP de deux compositions lubrifiantes comprenant de l'eau, l'une comprenant en outre un polysaccharide. Ces résultats montrent clairement qu'il est possible de détecter la présence de polysaccharides (présence d'un signal vers 103 ppm lié au carbone anomérique de la cellulose) et donc de discriminer les deux compositions étudiées.

### Exemple 1 : utilisation de l'agent de polarisation AMUPol dans une composition lubrifiante aqueuse

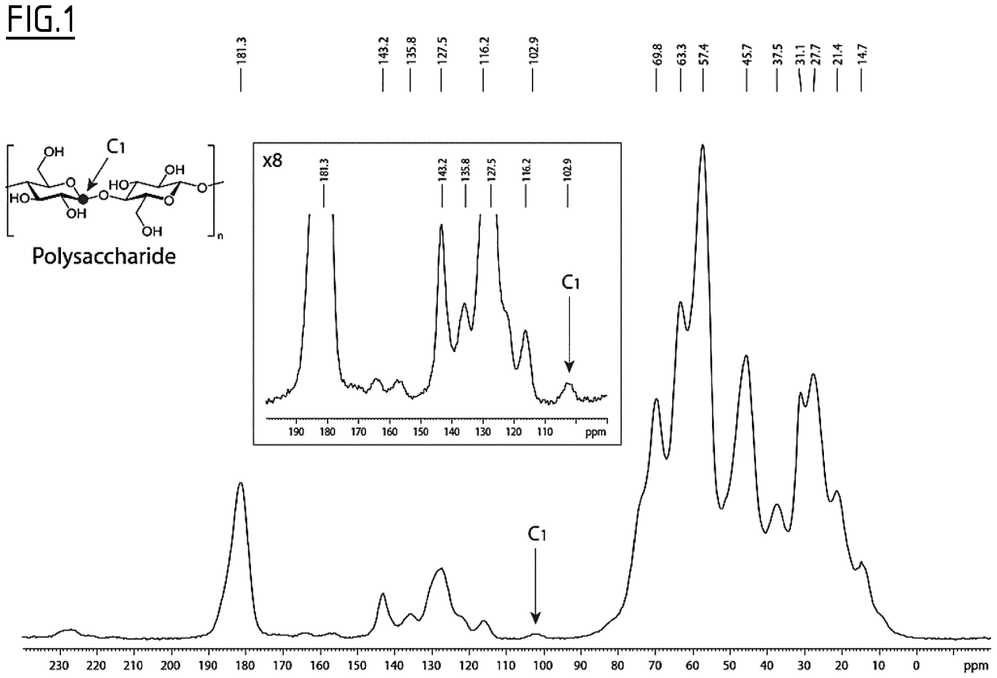

Dans 50 µL d'une composition comprenant de l'eau et un polysaccharide, on solubilise 0,36 mg d'AMUPol^{®} (un agent de polarisation DNP commercial disponible auprès de la société CortecNet). La solution ainsi obtenue est placée dans un rotor en saphir de 3,2 mm de diamètre externe à la température de 110 K sous une rotation de 10 kHz, et la fréquence de l'irradiation microonde du gyrotron est réglée à 263 GHz pour transférer la polarisation des radicaux de l'agent de polarisation aux noyaux ¹H de l'échantillon étudié. Cette polarisation est ensuite immédiatement transférée aux noyaux ¹³C de ce même échantillon par polarisation croisée selon l'expérience RMN appelée « CPMAS ». L'analyse RMN est réalisée sur un spectromètre RMN 400 MHz à diamètre d'introduction large (ou wide bore en anglais) pendant une durée de 50 min. Le résultat est montré en figure 1 et permet la détection d'un pic à environ 103 ppm correspondant aux polysaccharides.

### Exemple 2 : Méthode de discrimination entre deux compositions

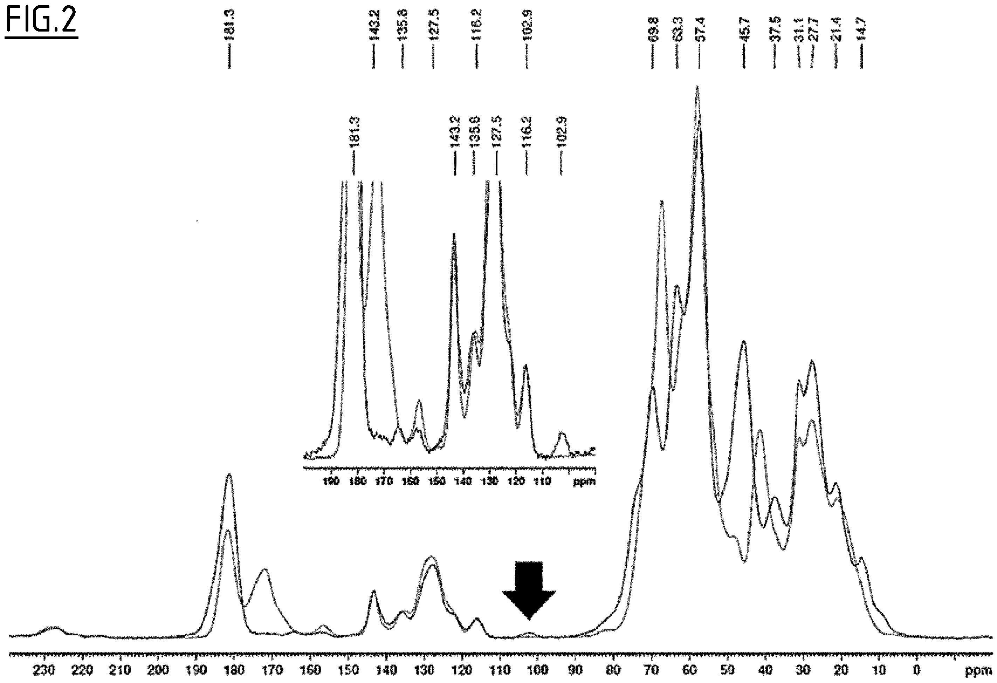

Dans 50 µL d'une composition (A) comprenant de l'eau et un polysaccharide, on solubilise 0,36 mg d'AMUPol^{®} (un agent de polarisation DNP commercial disponible auprès de la société CortecNet). La solution ainsi obtenue est placée dans un rotor en saphir de 3,2 mm de diamètre externe à la température de 110 K sous une rotation de 10 kHz, et la fréquence de l'irradiation microonde du gyrotron est réglée à 263 GHz pour transférer la polarisation des radicaux de l'agent de polarisation aux noyaux ¹H de l'échantillon étudié. Cette polarisation est ensuite immédiatement transférée aux noyaux ¹³C de ce même échantillon par polarisation croisée selon l'expérience RMN appelée « CPMAS » (le même essai pourrait être réalisé en polarisation directe (DPMAS). L'analyse RMN est réalisée sur un spectromètre RMN 400 MHz à diamètre d'introduction large (ou wide bore en anglais) pendant une durée de 50 min. On réalise ensuite exactement la même analyse, avec les mêmes conditions expérimentales, sur une composition lubrifiante commerciale (B) comprenant également de l'eau. Les deux spectres RMN DNP ainsi obtenus sont montrés et comparés en figure 2. Un pic à 103 ppm, correspondant aux polysaccharides, est détecté pour la composition (A) comprenant de l'eau et un polysaccharide. Un tel pic n'est pas détecté pour la composition lubrifiante (B). L'analyse menée permet de montrer que la composition (B) ne contient pas de polysaccharide.

### Exemple 3 : utilisation de l'agent de polarisation TEKPol dans une matrice pétrolière

Dans 50 µL d'une huile de base comprenant un polysaccharide, on solubilise 0,40 mg de TEKPol^{®} (un agent de polarisation DNP commercial disponible auprès de la société CortecNet). La solution ainsi obtenue est placée dans un rotor en saphir de 3,2 mm de diamètre externe à la température de 110 K sous une rotation de 10 kHz, et la fréquence de l'irradiation microonde du gyrotron est réglée à 263 GHz pour transférer la polarisation des radicaux de l'agent de polarisation aux noyaux ¹H de l'échantillon étudié. Cette polarisation est ensuite immédiatement transférée aux noyaux ¹³C de ce même échantillon par polarisation croisée selon l'expérience RMN appelée « CPMAS » (le même essai pourrait être réalisé en polarisation directe (DPMAS). L'analyse RMN est réalisée sur un spectromètre RMN 400 MHz à diamètre d'introduction large (ou wide bore en anglais) pendant une durée de 50 min.

Le résultat obtenu permet la détection d'un pic à environ 103 ppm correspondant aux polysaccharides.

## Revendications

1. Méthode de détection de la présence d'au moins un polysaccharide dans une composition lubrifiante aqueuse ou une matrice pétrolière, comprenant les étapes suivantes :
a) l'analyse RMN couplée à la polarisation nucléaire dynamique en phase solide à basse température et à l'angle magique de ladite composition lubrifiante aqueuse ou matrice pétrolière ;
b) la vérification de la présence d'un pic à un déplacement chimique compris entre 90 ppm et 110 ppm, de préférence 103 ppm correspondant à l'atome de carbone anomérique du cycle osidique du polysaccharide.

2. Méthode selon la revendication 1, comprenant une étape de quantification des polysaccharides par comparaison de l'intensité du pic de l'étape b) à celle du pic équivalent obtenue par analyse RMN couplée à la polarisation nucléaire dynamique en phase solide d'une composition comprenant une quantité connue de polysaccharide.

3. Méthode selon la revendication 1 ou 2, dans laquelle, avant l'étape a) un agent de transfert de polarisation DNP est ajouté à la composition lubrifiante aqueuse ou à la matrice pétrolière.

4. Méthode selon la revendication 3, dans laquelle l'agent de transfert de polarisation est choisi parmi la famille des nitroxydes, des trityls, ou de leurs dérivés.

5. Méthode selon l'une quelconque des revendications 1 à 4, dans laquelle dans l'étape de polarisation nucléaire dynamique la matrice pétrolière est mise à une température comprise entre 20 K et 200 K.

6. Méthode selon l'une quelconque des revendications 1 à 5, dans laquelle le rotor du système de polarisation nucléaire dynamique tourne à une fréquence comprise entre 1 kHz et 100 kHz.

7. Méthode selon l'une quelconque des revendications 1 à 6, dans laquelle l'irradiation pour le transfert de la polarisation dans l'étape de polarisation nucléaire dynamique est comprise entre 100 GHz et 700 GHz.

## Patentansprüche

1. Verfahren zum Detektieren des Vorhandenseins von mindestens einem Polysaccharid in einer wässrigen Schmiermittelzusammensetzung oder einer Erdölmatrix, umfassend die folgenden Schritte:
a) NMR-Analyse, gekoppelt mit dynamischer Kernpolarisation in Feststoffphase bei niedriger Temperatur, der wässrigen Schmiermittelzusammensetzung oder Erdölmatrix;
b) Verifizierung des Vorhandenseins eines Peaks bei einer chemischen Verschiebung zwischen 90 ppm und 110 ppm, vorzugsweise 103 ppm, das dem anomeren Kohlenstoffatom des osidischen Rings des Polysaccharids entspricht.

2. Verfahren nach Anspruch 1, umfassend einen Schritt eines Quantifizierens von Polysacchariden durch Vergleich der Intensität des Peaks von Schritt b) mit der des äquivalenten Peaks, der durch NMR-Analyse gekoppelt mit dynamischer Kernpolarisation in fester Phase einer Zusammensetzung, umfassend eine bekannte Menge an Polysaccharid, erlangt wird.

3. Verfahren nach Anspruch 1 oder 2, wobei vor Schritt a) ein Polarisationsübertragungsmittel DNP der wässrigen Schmiermittelzusammensetzung oder der Erdölmatrix hinzugefügt wird.

4. Verfahren nach Anspruch 3, wobei das Polarisationsübertragungsmittel ausgewählt ist aus der Familie der Nitroxide, Trityle oder deren Derivaten.

5. Verfahren nach einem der Ansprüche 1 bis 4, wobei in dem Schritt der dynamischen Kernpolarisation die Erdölmatrix auf eine Temperatur zwischen 20 K und 200 K gebracht wird.

6. Verfahren nach einem der Ansprüche 1 bis 5, wobei dem der Rotor des dynamischen Kernpolarisationssystems mit einer Frequenz zwischen 1 kHz und 100 kHz dreht.

7. Verfahren nach einem der Ansprüche 1 bis 6, wobei die Bestrahlung für die Übertragung der Polarisation in dem Schritt der dynamischen Kernpolarisation zwischen 100 GHz und 700 GHz liegt.

## Claims

1. A method for detecting the presence of at least one polysaccharide in an aqueous lubricant composition or petroleum matrix, comprising the following steps:
a) NMR analysis coupled with dynamic nuclear polarisation in the solid phase at low temperature and at the magic angle of the said aqueous lubricant composition or petroleum matrix;
b) checking for the presence of a peak with a chemical shift of between 90 ppm and 110 ppm, preferably 103 ppm, corresponding to the anomeric carbon atom of the osidic ring of the polysaccharide.

2. The method according to claim 1, comprising a step of quantifying the polysaccharides by comparing the intensity of the peak from step b) with that of the equivalent peak obtained by solid-phase NMR analysis coupled with dynamic nuclear polarisation of a composition comprising a known quantity of polysaccharide.

3. The method according to claim 1 or 2, wherein prior to step a) a DNP polarisation transfer agent is added to the aqueous lubricant composition or petroleum matrix.

4. The method according to claim 3, wherein the polarisation transfer agent is chosen from the family of nitroxides, trityls or derivatives thereof.

5. The method according to any one of claims 1 to 4, wherein in the dynamic nuclear polarisation step the petroleum matrix is brought to a temperature of between 20 K and 200 K.

6. The method according to any one of claims 1 to 5, wherein the rotor of the dynamic nuclear polarisation system rotates at a frequency of between 1 kHz and 100 kHz.

7. The method according to any one of claims 1 to 6, in which the irradiation for transferring the polarisation in the dynamic nuclear polarisation step is between 100 GHz and 700 GHz.
